# EUROPÄISCHE PATENTANMELDUNG

(11) **EP 2 017 732 A1**
(43) Veröffentlichungstag der Anmeldung: **21.01.2009**
(21) Anmeldenummer: 07012310.4
(22) Anmeldetag: 22.06.2007
(51) Int. Cl.: G06F 9/45, H03M 7/30

(54) **Verfharen und Vorrichtung zum Komprimieren einer Software für eine Steuereinrichtung**

(71) Anmelder: Continental Automotive GmbH, 30165 Hannover (DE)
(72) Erfinder: Brüll, Martin, 93092 Barbing (DE); Burger, Thomas, 93051 Regensburg (DE); Kunze, Marco, 93083 Obertraubling (DE); Reuther, Achim, 95346 Stadtsteinach (DE)

(57) **Zusammenfassung**

Die vorliegende Erfindung betrifft ein Verfahren und eine Vorrichtung (200) zum Komprimieren einer Software für eine Steuereinrichtung (100), insbesondere eine Motorsteuereinrichtung. Erfindungsgemäß wird ein binäres Bitmusters für einen ersten Bestandteil der Software in einem Speicherbereich (216) abgespeichert. Das abgespeicherte Bitmuster wird ferner für einen zweiten Bestandteil der Software wiederverwendet.

## Beschreibung

Die vorliegende Erfindung betrifft ein Verfahren und eine Vorrichtung zum Komprimieren einer Software für eine Steuereinrichtung, insbesondere eine Motorsteuereinrichtung.

Die Steuerung von vielfältigen komplizierten Prozessen in modernen Verbrennungskraftmaschinen, insbesondere für Kraftfahrzeuge, zählt zu den wichtigen Anwendungsbereichen der Mikroelektronik. Dabei spielen beispielsweise die Regelungen der elektronischen Zündsysteme und der Leerlauf-Drehzahl sowie die Lambdaregelung eine herausragende Rolle. Aktive Motorregelungen und adaptive Getrieberegelungen sind wesentliche Mittel zur Anpassung der Systeme an die jeweiligen Fahrsituationen. Diese Regelungsmechanismen werden durch moderne Motorsteuereinrichtungen realisiert.

Die Motorsteuereinrichtungen werden durch die Hersteller jeweils mit einer Steuersoftware ausgestattet. Diese Software ist umfangreich und komplex, da sie eine große Vielzahl von Anweisungen zum Ausführen der Regelungsmechanismen umfasst. Mit wachsenden Anforderungen an die Verbrennungskraftmaschinen, wie beispielsweise das Erfüllen bestimmter Abgasnormen und das Einhalten von vorgegebenen Verbrauchswerten, ist der Umfang der Steuersoftware stark angestiegen. Ein weiterer Anstieg des Umfangs ist zudem für die Zukunft zu erwarten. Zum Abspeichern der umfangreichen Steuersoftware sind daher große Speicherkapazitäten erforderlich. Dies ist aufwändig und kostspielig. Nachteiligerweise kann sogar eine Beschränkung der Funktionalität der Software vorgenommen werden, um die erforderliche Größe der Speicherkapazitäten zu begrenzen. Dies kann unter Umständen allerdings dazu führen, dass nicht alle gewünschten Anforderungen tatsächlich erfüllt werden können.

Der vorliegenden Erfindung liegt die Aufgabe zugrunde, eine zum Abspeichern einer Software für eine Steuereinrichtung, insbesondere eine Motorsteuereinrichtung, erforderliche Speicherkapazität klein halten zu können.

Diese Aufgabe wird verfahrensseitig durch die technische Lehre des Anspruchs 1, 15 oder 16 und vorrichtungsseitig durch die technische Lehre des Anspruchs 18, 19 oder 20 gelöst. Vorteilhafte Ausgestaltungen der Erfindung können den abhängigen Ansprüchen entnommen werden.

Erfindungsgemäß wird ein Komprimieren einer Software für eine Steuereinrichtung, insbesondere eine Motorsteuereinrichtung, durchgeführt. Dabei wird ein binäres Bitmuster für einen ersten Bestandteil der Software in einem Speicherbereich abgespeichert und das abgespeicherte Bitmuster für einen zweiten Bestandteil der Software wiederverwendet. Die erfindungsgemäße Vorrichtung zum Komprimieren der Software für die Steuereinrichtung weist einen Speicher und eine Steuereinheit auf, die mit dem Speicher verbunden ist. Die Vorrichtung ist dabei so ausgestaltet, dass sie ein binäres Bitmuster für einen ersten Bestandteil der Software in einem Speicherbereich des Speichers abspeichert und das abgespeicherte Bitmuster für einen zweiten Bestandteil der Software wiederverwendet.

Die Software setzt sich hier insbesondere aus einem Programmcode mit einer Vielzahl von Ablaufbefehlen und einem Datensatz mit einer Vielzahl von Daten zusammen. Der Programmcode kann während des Ablaufs der Software auf Daten des Datensatzes zugreifen. Programmcode und Datensatz können vorteilhafterweise getrennt voneinander in einem Speicher abgespeichert sein. Nach dem Erstellen der Software, d. h. dem Programmieren, und gegebenenfalls einem Kompilieren und einem Linken wird die Komprimierung der erstellten Software auf erfindungsgemäße Weise durchgeführt. Die komprimierte Software ist lauffähig und kann in einem Speicher der Steuereinrichtung abgespeichert werden, um von der Steuereinrichtung ausgeführt zu werden. Durch das erfindungsgemäße Komprimieren der Software kann ein binäres Bitmuster einmalig abgespeichert und für mehrere Bestandteile der Software, verwendet werden. Dadurch kann die Speicherkapazität des Speichers vorteilhafterweise gering gehalten werden. Daraus resultiert eine kostengünstige Ausgestaltung der Steuereinrichtung. Ferner kann aufgrund der vorliegenden Erfindung ein besonders hoher Schutz vor unerlaubten Modifikationen der Software erreicht werden. Solche unerlaubten Modifikationen können eventuell von Dritten unerwünschterweise ausgeführt werden und problematische und gegebenenfalls gefährliche Betriebszustände des Systems herbeiführen, das durch die Funktionalität der Steuersoftware gesteuert wird.

Als Bestandteile der Software, die insbesondere eine binäre Software ist, können hier beliebige Teile der Software betrachtet werden. Die Bestandteile können dem Programmcode und/oder dem Datensatz entstammen. Bestandteile können beispielsweise Zeichen, Zahlen, Buchstaben, Befehle, Funktionen, etc. sein. Abhängig von der Art der Bestandteile kann beispielsweise ein bestimmter Kompressionsgrad festgelegt werden. Das Bitmuster ist hier insbesondere eine Aufeinanderfolge von mehreren Bits. Vorteilhafterweise kann das Bitmuster aufgrund der vorliegenden Erfindung zum Abspeichern oder zum Erfassen des ersten und des zweiten Bestandteils, d. h. mehrerer Bestandteile der Software, in binärer Form oder in binärer Darstellung in dem Speicherbereich abgespeichert werden. Insbesondere weisen die mehreren Bestandteile dabei in ihrer binären Form das Bitmuster auf. Für jedes der mehreren Bestandteile wird einfachheitshalber ein Bezug, z. B. mittels eines Zeigers, zu dem abgespeicherten Bitmuster hergestellt. Das abgespeicherte Bitmuster ist somit zum Ausführen der mehreren Bestandteile der Software mehrfach verwendbar. Die Steuereinrichtung kann als Motorsteuereinrichtung besonders vorteilhaft zum Steuern eines Motors eines Kraftfahrzeugs dienen. Es ist aber ebenso möglich, die vorliegende Erfindung in anderen Einsatzgebieten anzuwenden, insbesondere bei Getriebesteuerungen, PCs, Servern, Datenbanken und deren Betriebssysteme sowie generell auf Daten und Dateien, beispielsweise zur Dateienkomprimierung.

In einer vorteilhaften Ausgestaltung der Erfindung sind der erste Bestandteil und der zweite Bestandteil Daten eines Datensatzes der Software, die gleiche Werte aufweisen. Dadurch kann einfachheitshalber ein hoher Kompressionsgrad bei begrenztem Kompressionsaufwand erreicht werden. Die Bitmuster von Daten mit unterschiedlichen Werten müssen vorteilhafterweise nur ein einziges Mal abgespeichert werden. Damit sind dann die Bitmuster aller in der Software auftretenden, verschiedenen Werte erfasst. Zum Abspeichern der Daten der Software mit verschiedenen Werten kann daher auf die jeweils ein einziges Mal abgespeicherten Bitmuster für die Daten mit unterschiedlichen Werten verwiesen werden. Dies kann insbesondere durch Zeiger erfolgen, die auf die Speicheradressen der Bitmuster zeigen. Die Werte können beispielsweise bestimmte physikalische Werte sein, die z. B. Angaben zur Temperatur machen. Besonders vorteilhaft wird das abgespeicherte Bitmuster für alle Bestandteile der Software verwendet, die Daten der Software mit gleichen Werten sind. Vorteilhafterweise können in diesem Fall somit alle Daten mit demselben Bitmuster in ihren binären Formen durch Wiederverwendung dieses Bitmusters auf eine einzige Speicherstelle reduziert werden.

In einer weiteren, besonders vorteilhaften Ausgestaltung sind die Daten zusätzlich Daten eines gleichen Datentyps. Der Datentyp ist somit ein zusätzliches Kriterium zum Komprimieren. Der Kompressionsgrad ist hier niedriger als beim Komprimieren von Daten ohne das zusätzliche Kriterium des Datentyps. Allerdings ist der Kompressionsaufwand vorteilhafterweise ebenfalls geringer. Der Datentyp kann sich beispielsweise aus der Anzahl der Stellen der Daten, daraus, ob die Daten mit oder ohne Vorzeichen angegeben werden, oder ob sie Gleitkommadaten oder Daten mit einer festen Kommastelle sind, etc., ergeben.

In diesem Fall können somit alle Daten gleichen Datentyps und gleichen Werts durch Wiederverwendung des Bitmusters auf eine einzige Speicherstelle reduziert werden. Anstelle des Begriffs Datentyp kann insbesondere auch der Begriff Datenformat verwendet werden.

Bevorzugt sind der erste Bestandteil und der zweite Bestandteil der Software Daten. Der erste Bestandteil ist in binärer Form in Bytes aufgeteilt, die einzeln adressierbar sind. Dabei wird ein oder ein Vielfaches eines solchen Bytes als Bitmuster für den zweiten Bestandteil, insbesondere zum Abspeichern des zweiten Bestandteils in binärer Form, wiederverwendet. Bei dieser Art des Komprimierens kann vorteilhafterweise ein hoher Kompressionsgrad erreicht werden. Es wird in diesem Fall insbesondere eine Wiederverwendung von Bitmustern betrieben, bei der eine Adressierung der abgespeicherten Bitmuster auf Basis eines Vielfachen eines Bytes, insbesondere auf Bytebasis, erfolgt.

Besonders bevorzugt sind der erste Bestandteil und der zweite Bestandteil der Software Daten und der erste Bestandteil ist in binärer Form bitweise adressierbar. Dabei wird ein Vielfaches eines solchen Bits als Bitmuster für den zweiten Bestandteil, insbesondere zum Abspeichern des zweiten Bestandteils in binärer Form, wiederverwendet. Bei dieser Art des Komprimierens kann vorteilhafterweise ein besonders hoher Kompressionsgrad erreicht werden. In diesem Fall wird insbesondere eine Wiederverwendung von Bitmustern betrieben, bei der eine Adressierung der abgespeicherten Bitmuster auf Basis eines Vielfachen eines Bits, insbesondere auf Bitbasis, erfolgt.

Des Weiteren vorzugsweise wird überprüft, insbesondere zum Abspeichern des zweiten Bestandteils der Software, ob der zweite Bestandteil in binärer Form ein solches Bitmuster aufweist, das bereits zuvor für den ersten Bestandteil abgespeichert wurde, insbesondere zum Abspeichern des ersten Bestandteils. Falls dies der Fall ist, wird dieses bereits abgespeicherte Bitmuster für den zweiten Bestandteil, insbesondere zum Abspeichern des zweiten Bestandteils, wiederverwendet. Falls dies nicht der Fall ist, wird das noch nicht abgespeicherte Bitmuster des zweiten Bestandteils anschließend an ein letztes, in dem Speicherbereich abgespeichertes Bitmuster neu abgespeichert. Das noch nicht abgespeicherte Bitmuster wird somit am Ende eines zum Abspeichern von Bitmustern in dem Speicherbereich benutzten Bitmusterbereichs abgespeichert. Dieser Ablauf von Arbeitsschritten des erfindungsgemäßen Verfahrens ist besonders schnell. Das Verhältnis von zum Komprimieren erforderlichem Rechenaufwand und Speicherplatzgewinn ist hier vorteilhafterweise besonders gut.

Besonders bevorzugt werden Bestandteile der Software, die Daten sind, daraufhin untersucht, ob sie in ihren binären Formen wenigstens ein gleiches Bitmuster aufweisen. Abhängig von einem Ergebnis dieses Untersuchens werden die Daten sortiert. Bei dieser Art des Komprimierens kann vorteilhafterweise eine besonders gute Ausnutzung des Speicherbereichs erreicht werden. Der Kompressionsgrad ist somit besonders hoch. Das Untersuchen der Daten erfolgt insbesondere vor ihrem Abspeichern in binärer Form. Ferner erfolgt das Sortieren der untersuchten Daten vorteilhafterweise zum Abspeichern in binärer Form.

Bevorzugt werden zum Adressieren von mehreren abgespeicherten Bitmustern Zeiger verwendet, die ausgehend von einer Speicheradresse des Speicherbereichs auf Speicheradressen der mehreren abgespeicherten Bitmuster verweisen. Solche Zeiger benötigen vorteilhafterweise nur sehr wenig Speicherplatz. Die Speicheradresse, von der die Zeiger ausgehen, kann als Offset-Speicheradresse bezeichnet werden. Die Zeiger geben insofern relative Speicheradressen an und können auch als relative Zeiger bezeichnet werden. Die Zeiger definieren zum Adressieren der Speicheradressen der mehreren abgespeicherten Bitmuster Abweichungen von der Offset-Speicheradresse. Auf diese besonders einfache Weise können beispielsweise Arrays, insbesondere mehrdimensionale Arrays, oder Elemente von Arrays, wie z. B. Matrizen, adressiert werden. Anstelle der eigentlichen Variablenwerte für die abgespeicherten Bitmuster können vorteilhafterweise somit die Zeiger zum Adressieren eingesetzt werden.

Besonders bevorzugt ist der erste Bestandteil der Software Teil eines Programmcodes der Software und der zweite Bestandteil der Software Teil eines Datensatzes der Software. Auf diese Weise können abgespeicherte Bitmuster für das Abspeichern des Programmcodes in binärer Form zum Abspeichern von Daten in binärer Form wiederverwendet werden. Dies ermöglicht vorteilhafterweise einen besonders hohen Kompressionsgrad. Da prinzipiell jedes Bitmuster für Daten zulässig ist, finden sich im Maschinencode bestimmte Bitmuster wieder, die als Variableninhalt wiederverwendet werden können.

Des Weiteren vorzugsweise wird ein Programmcode der Software zum Ermitteln von Teilen des Programmcodes analysiert, die gleiche oder ähnliche Funktionalitäten haben. Ferner wird ein zentraler Programmteil für den Programmcode erzeugt, der in der Lage ist, die Funktionalitäten der ermittelten Teile des Programmcodes zu erfüllen. Des Weiteren wird der Programmcode so verändert, dass der erzeugte zentrale Programmteil für den Ablauf des Programmcodes anstelle der ermittelten Teile des Programmcodes verwendet wird. Diese Vorgehensweise gewährleistet vorteilhafterweise einen sehr hohen Kompressionsgrad. Es ist möglich, den binären Programmcode strukturell nach gleichen oder ähnlichen Konstrukten, d. h. insbesondere Bitmustern, zu untersuchen. Ähnliche Konstrukte können beim Erzeugen des zentralen Programmteils vor allem über eine Makrofunktion wiedergegeben werden. Durch die Makrofunktion können beispielsweise bestimmte Stellen des Bitmusters verändert werden, während die übrigen Stellen des Bitmusters gleich bleiben. Durch das Erzeugen des zentralen Programmteils können insbesondere Rechenoperationen, wie z. B. eine Integration, oder Kombinationen von Rechenoperationen wiederverwendet werden. Beim Verändern des Programmcodes wird dieser mittels funktioneller Wiederverwendung von zentralen Programmteilen anstelle der ermittelten Teile des Programmcodes reorganisiert. Der Begriff Programmcode kann hier insbesondere sowohl den Code der Software selbst als auch den Datensatz umfassen. Mit der angegebenen Vorgehensweise kann vorteilhafterweise ein besonders guter Modifikationsschutz der Software vor unerlaubten oder nicht erwünschten Modifikationen erreicht werden. Dadurch, dass der Programmcode als Quelle für Daten verwendet wird, hat jede noch so kleine Veränderung oder Modifikation des Programmcodes Einfluss auf möglicherweise viele Daten. Die Modifikation würde insofern zu einer fehlerhaften Ausführung der gesamten Software führen. Diejenigen Teile der Software, die eventuell mutwillig und bewusst modifiziert wurden, haben somit Einfluss auf das Gesamtverhalten der Software. Es ist folglich vorteilhafterweise nicht möglich, Änderungen am Programmcode vorzunehmen, sofern die Grundfunktionalität der Software erhalten bleiben soll. Ein mutwilliges Modifizieren der Software durch Endanwender kann weitgehend ausgeschlossen werden, da nahezu kein Datum der Software separat verändert werden kann.

Besonders bevorzugt wird zum Komprimieren des Programmcodes der Software zunächst der Programmcode der Software zum Ermitteln von Teilen des Programmcodes analysiert, die gleiche oder ähnliche Funktionalitäten haben. Ferner wird der zentrale Programmteil für den Programmcode erzeugt, der in der Lage ist, die Funktionalitäten der ermittelten Teile des Programmcodes zu erfüllen. Des Weiteren wird der Programmcode so verändert, dass der erzeugte zentrale Programmteil für den Ablauf des Programmcodes anstelle der ermittelten Teile des Programmcodes verwendet wird. Dann wird zum Reduzieren einer Menge von Daten des Datensatzes der Software ein zum Abspeichern eines Teils des Programmcodes der Software abgespeichertes Bitmuster ebenfalls zum Abspeichern von Daten des Datensatzes der Software verwendet. Anschließend werden zum Komprimieren der reduzierten Menge von Daten die Daten dieser reduzierten Menge vor ihrem Abspeichern in binärer Form daraufhin untersucht, ob sie in ihren binären Formen wenigstens ein gleiches Bitmuster aufweisen. Abhängig von dem Ergebnis dieses Untersuchens werden die Daten zum Abspeichern in binärer Form sortiert. Das Komprimieren des Programmcodes, das Reduzieren der Menge von Daten und das Komprimieren der reduzierten Menge von Daten wird vorteilhafterweise iterativ durchgeführt. Es ist auf diese Weise möglich, ein simultanes Komprimieren von Programmcode und von Daten durchzuführen. Dies gewährleistet vorteilhafterweise ein schnelles Komprimieren mit einem hohen Kompressionsgrad.

In einer weiteren, besonders vorteilhaften Ausgestaltung werden in einem sogenannten Random Access Memory, RAM, insbesondere einem zum Kalibrieren von Daten eingesetzten Kalibrierungs-RAM, Zeiger abgespeichert, die auf Daten verweisen, die in binärer Form in einem anderen Speicher abgespeichert sind. Die Zeiger benötigen vorteilhafterweise besonders wenig Speicherplatz, so dass der RAM-Baustein eine besonders geringe Speicherkapazität aufweisen kann. Bei dieser erfindungsgemäßen Lösung können insofern Daten, die in dem RAM abgespeichert werden sollen, vor dem Abspeichern komprimiert werden. Beim Kalibrieren können beispielsweise von einem Benutzer bestimmte Daten exakt vorgegeben werden. Dadurch kann beispielsweise eine Temperaturschwelle oder ein Dämpfungswert vorgegeben werden. Der andere Speicher kann insbesondere eine Festplatte sein. Es sind hier aber auch andere Massenspeichermedien einsetzbar.

Bevorzugt werden nach dem Kalibrieren, und damit einem Verändern von Daten, in dem Kalibrierungs-RAM abgespeicherte Zeiger geändert, so dass sie auf solche in dem anderen Speicher in binärer Form abgespeicherte Daten verweisen, die die kalibrierten Daten in binärer Form wiedergeben. Für den Anwender bleibt dadurch vorteilhafterweise die gleiche Funktionalität bestehen, wie vor dem Kalibrieren. Mit einem Kalibrierungssystem und einem Softwarebeschreibungsformat als Basis für das Kalibrierungssystem kann eine Anzeige von Informationen, insbesondere von Zahlen, beispielsweise auf einem Monitor, und die Modifikation der Kalibrierungsdaten derart umgesetzt werden, dass die Funktionalitäten für den Anwender erhalten bleiben.

Besonders bevorzugt ist wenigstens ein Bestandteil der Software in seiner binären Form aus mehreren Bitmustern zusammengesetzt, die in dem Speicherbereich abgespeichert sind und einzeln, insbesondere mittels Zeigern, adressiert werden. Dadurch ist vorteilhafterweise ein besonders hoher Kompressionsgrad erreichbar. Eine große Anzahl von abgespeicherten Bitmustern kann besonders häufig zum Abspeichern von weiteren Bestandteilen der Software wiederverwendet werden. Insbesondere große Bitmuster können insofern aus mehreren Teil-Bitmustern zusammengestellt werden. Diese Vorgehensweise ist sowohl auf den Programmcode als auch auf Daten anwendbar.

Zum erfindungsgemäßen Ausführen der Software, insbesondere der komprimierten Software, wird ein Betriebssystem eingesetzt, dessen Befehlssatz Befehle aufweist, mit denen eine Adressierung von Daten auf Basis eines Vielfachen eines Bits durchgeführt wird. Das erfindungsgemäße Betriebssystem enthält somit einen Befehlssatz mit Befehlen, mit denen eine Adressierung von Daten auf Basis eines Vielfachen eines Bits durchführbar ist. Besonders bevorzugt weist die Steuereinrichtung, insbesondere die Motorsteuereinrichtung, ein solches Betriebssystem auf. Mit einem solchen Betriebssystem lässt sich auf besonders komfortable Weise die entsprechend komprimierte Software effizient ausführen.

Gemäß einem weiteren Aspekt der vorliegenden Erfindung ist zum Ausführen der Software, insbesondere der komprimierten Software, eine Recheneinheit, insbesondere ein Prozessor, vorhanden, mit dem eine Adressierung von Daten auf Basis eines Vielfachen eines Bits durchgeführt wird. Die erfindungsgemäße Recheneinheit ist somit so ausgestaltet, dass die Adressierung von Daten auf Basis des Vielfachen eines Bits durchführbar ist. Besonders bevorzugt weist die Steuereinrichtung, insbesondere die Motorsteuereinrichtung, eine solche Recheneinheit, insbesondere einen solchen Prozessor, auf. Mit einem solchen Prozessor lässt sich ebenfalls auf komfortable Weise die entsprechend komprimierte Software effizient ausführen.

Nachfolgend werden die Erfindung und ihre Vorteile anhand von Beispielen und Ausführungsbeispielen und der beigefügten Zeichnung näher erläutert. Es zeigen:
- Fig. 1: eine schematische Darstellung eines Motorsteuergeräts für ein Kraftfahrzeug,
- Fig. 2: ein Ausführungsbeispiel einer erfindungsgemäßen Vorrichtung zum Komprimieren einer Software,
- Fig. 3: ein Ausführungsbeispiel eines erfindungsgemäßen Verfahrens, mit dem ein Komprimieren mittels Wiederverwenden von abgespeicherten Bitmustern durchgeführt wird,
- Fig. 4: einen Ausschnitt eines Speicherbereichs eines Speichers mit einer Vielzahl von aufeinander folgenden, adressierbaren Speicherplätzen zum Abspeichern von Bitmustern und
- Fig. 5: ein Beispiel eines Verfahrens zum Komprimieren von Programmcode der Software.

In den Figuren sind nachfolgend gleiche oder funktionsgleiche Elemente - sofern nichts anderes angegeben ist - mit denselben Bezugszeichen versehen.

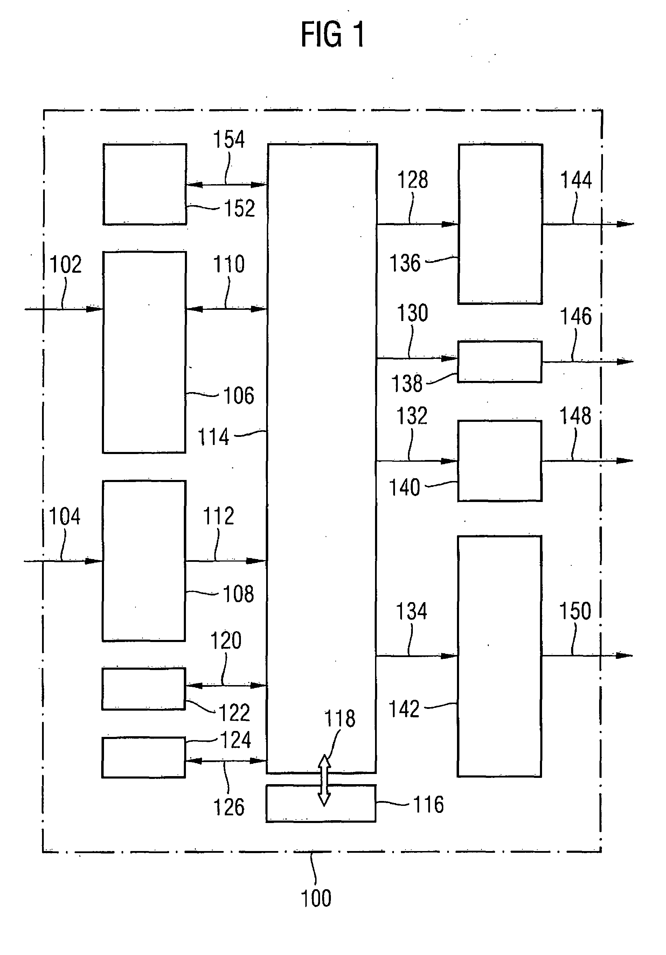

Fig. 1 zeigt eine Motorsteuerung 100 zum Steuern eines Motors eines Kraftfahrzeugs. Bei der Motorsteuerung 100 erfolgen ein Signalfluss 102 von verschiedenen Sensoren und Sollwertgebern, wie z. B. Fahrpedaleinstellung, Drosselklappenstellung, Luftmasse, Batteriespannung, Ansauglufttemperatur, Motortemperatur, Klopfintensität, Lambda-Sonden, und ein Signalfluss 104, wie z. B. Kurbelwellendrehzahl, Nockenwellenstellung, Getriebestufe, Geschwindigkeit, über Input/Output-Ports 106 und 108 und weiter von den Ports 106, 108 über Verbindungen 110 und 112 zu einem Mikroprozessor oder einem Mikrocontroller 114 und seinen Komponenten. In einem OTP (One-Time Programmable)-Block mit einem Speicher 116 ist ein Programm, d. h. eine Software, gespeichert, welches der Mikroprozessor 114 zum Steuern der Motorsteuerung 100 ausführen soll. Der Datenfluss zwischen Mikroprozessor 114 und dem Speicher 116 erfolgt über eine Verbindung 118. Über eine Verbindung 120 erfolgt ein Datentransfer zwischen dem Mikroprozessor 114 und einem CAN-Bus 122. Der CAN-Bus 122 ermöglicht es, alle Geräte über ein einziges Kabel miteinander zu vernetzen. Ein Datentransfer zwischen dem Mikroprozessor 114 und einem Diagnosesystem 124 erfolgt über eine Verbindung 126.

Der Mikroprozessor 114 mit seinen Komponenten realisiert seine Funktionen auf der Grundlage des im Speicher 116 gespeicherten Programms. Dazu verwendet der Mikroprozessor 114 ein in einem Speicherbereich abgespeichertes Betriebssystem 156. Nach der Verarbeitung der Signale von den Sensoren und Sollwertgebern 102, 104 im Mikroprozessor 114 erfolgt der weitere Signalfluss vom Mikroprozessor 114 über Verbindungen 128, 130, 132, 134 und über Input/Output-Ports 136, 138, 140, 142 zu verschieden Aktoren 144, z. B. Zündspulen und Zündkerzen, Aktoren 146, z. B. Drosselklappensteller, Aktoren 148, z. B. Einspritzventile und Aktoren 150, z. B. Hauptrelais, Motordrehzahlmesser, Kraftstoffpumpenrelais, Heizung, LambdaSonde, Nockenwellensteuerung, Tankentlüftung, Saugrohrumschaltung, Sekundärluft, Abgasrückführung. Die Motorsteuerung 100 enthält hier ferner einen Random Access Memory, RAM, Speicher 152, der über eine bidirektionale Verbindungsleitung 154 mit dem Mikroprozessor 114 verbunden ist. Der RAM-Speicher 152 kann hier insbesondere ein Kalibrierungs-RAM zum Abspeichern von einem Benutzer kalibrierten Daten sein.

Aufgrund ihrer zahlreichen Ein- und Ausgangsgrößen sind die Regelungen in Kraftfahrzeugen sehr komplex, so dass zur Realisierung der Aufgaben moderne Regelungssysteme auf der Basis von Mikroprozessoren oder Mikrocontrollern eingesetzt werden. Da in modernen Kraftfahrzeugen immer mehr unterschiedliche Sensoren zum Einsatz kommen, deren Messdaten zeitnah berücksichtigt und verarbeitet werden müssen, werden zunehmend Mikroprozessoren 114 mit sehr hoher Rechenleistung eingesetzt. Die Steuersoftware muss dabei eine große Anzahl von Funktionalitäten enthalten und erfüllen. Um den Speicher 116 kostengünstig mit einer begrenzten Speicherkapazität ausgestalten zu können, wird die Steuersoftware nach ihrem Erstellen erfindungsgemäß komprimiert. Dadurch wird der Umfang der im Speicher 116 abzuspeichernden Steuersoftware gering gehalten.

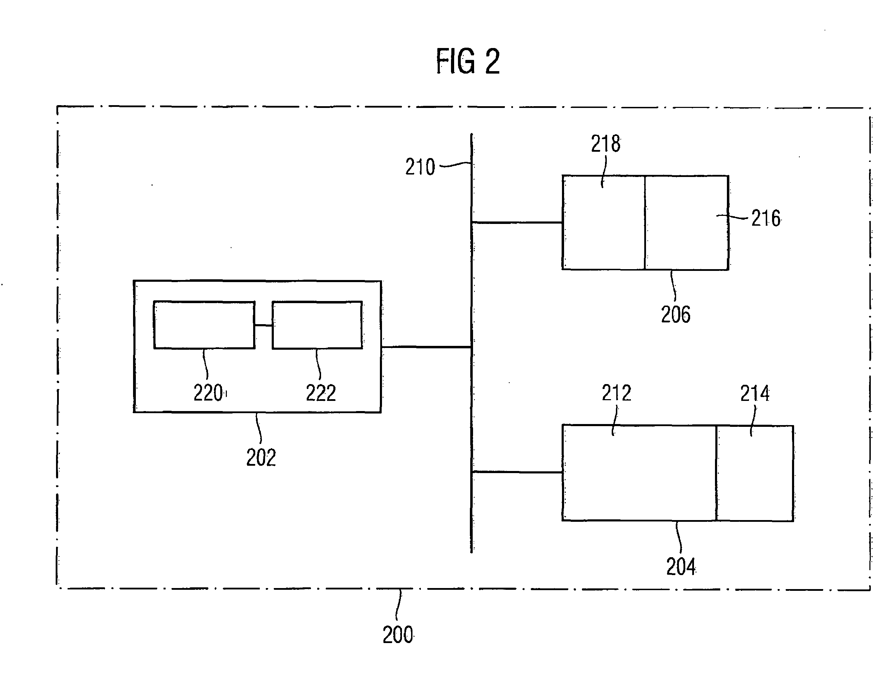

Fig. 2 zeigt ein Ausführungsbeispiel einer erfindungsgemäßen Vorrichtung 200 zum Komprimieren der in dem Speicher 116 abzuspeichernden Software für die Steuereinrichtung 100. Die Vorrichtung 200 enthält eine Steuereinheit 202 zum Steuern des Komprimierens der Software, einen Speicher 204 zum Abspeichern der erstellten, nicht komprimierten Software und einen weiteren Speicher 206 zum Abspeichern der komprimierten Software. Die Steuereinheit 202 sowie die Speicher 204 und 206 sind an einen Bus 210 angeschlossen, über den Informationen und Daten ausgetauscht werden können.

Die erstellte Software weist einen Programmcode mit einer Vielzahl von Ablaufbefehlen und einen Datensatz mit einer Vielzahl von Daten auf. Der Programmcode greift während des Ablaufs der Software auf Daten des Datensatzes zu. Programmcode und Datensatz sind hier getrennt voneinander in dem Speicher 204 abgespeichert. Dazu weist der Speicher 204 einen Programmcodebereich 212 für den Programmcode und einen Datensatzbereich 214 für den Datensatz auf. Der Speicher 206 weist einen Speicherbereich 216 auf, in dem Bitmuster nacheinander und aufeinander folgend abgespeichert werden. Diese Bitmuster enthalten mehrere Bits und können zum Abspeichern der Software mehrfach verwendet werden. Jedes der in dem Speicherbereich 216 abgespeicherten Bitmuster dient zum Abspeichern von wenigstens zwei Bestandteilen der Software in binärer Form. Dabei enthalten diese wenigstens zwei Bestandteile der Software in ihren binären Formen diese Bitmuster. In einem anderen Speicherbereich 218 des Speichers 206 sind im vorliegenden Ausführungsbeispiel Zeiger als Teil der komprimierten Software abgelegt, die auf Speicheradressen zeigen, unter denen die Bitmuster im Speicherbereich 216 abgespeichert sind. Über diese Zeiger können daher die abgespeicherten Bitmuster verwendet werden.

Die in dem Speicher 206 abgespeicherte komprimierte Software wird hier in den Speicher 116 der Motorsteuerung 100 übertragen. Die komprimierte Software ist lauffähig, so dass die Motorsteuerung 100 mittels dieser komprimierten Software den Motor steuert. Der Mikroprozessor 114 steuert das Ausführen der komprimierten Software. Im vorliegenden Ausführungsbeispiel ist der Mikroprozessor 114 ein spezieller Prozessor oder eine spezielle Prozessorbauart, der so ausgestaltet ist, dass eine Adressierung von Daten auf Basis eines Vielfachen eines Bits durchführbar ist. Alternativ oder zusätzlich ist es möglich, dass das Betriebssystem 156 einen Befehlssatz mit Befehlen aufweist, mit denen eine Adressierung von Daten auf Basis eines Vielfachen eines Bits durchgeführt werden kann. Die in dem Speicher 116 abgespeicherte Software ist dann entsprechend aufgebaut, um diese Eigenart des Prozessors 114 und/oder des Betriebssystems 156 nutzen zu können.

Das Betriebssystem kann beispielsweise für einen bestimmten Datentyp der Daten des Datensatzes der Software mehrere Lesebefehle aufweisen. D. h., anstelle eines einzigen Lesebefehls für den Datentyp sind z. B. acht Lesebefehle verfügbar. Dabei kann für jeden der mehreren Lesebefehle zur Angabe einer Speicheradresse ein bestimmter Bit-Offset hinzukommen. Beispielsweise könnte ein Satz solcher Lesebefehle für den Datensatz folgendermaßen lauten:
1. Befehl: Gehe zum ersten Bit und lese 16 Bit aus.
2. Befehl: Gehe zum zweiten Bit und lese 16 Bit aus.
3. Befehl: Gehe zum dritten Bit und lese 16 Bit aus.
4. Befehl: Gehe zum vierten Bit und lese 16 Bit aus.
5. Befehl: Gehe zum fünften Bit und lese 16 Bit aus.
6. Befehl: Gehe zum sechsten Bit und lese 16 Bit aus.
7. Befehl: Gehe zum siebten Bit und lese 16 Bit aus.
8. Befehl: Gehe zum achten Bit und lese 16 Bit aus.

Durch ein solches Betriebssystem 156 und/oder einen solchen Prozessor 114 kann das Ausführen der entsprechend komprimierten Software besonders effizient durchgeführt werden.

Das Komprimieren kann besonders vorteilhaft mit Zeigern realisiert werden, die insbesondere auf abgespeicherte Bitmuster verweisen. Abhängig davon, welche Bestandteile der Software zum Komprimieren zugelassen werden, können unterschiedlich hohe Kompressionsgrade beim Komprimieren der Software erreicht werden. Besonders einfach und effizient lässt sich die Software durch das Komprimieren der Daten des Datensatzes komprimieren. Es ist beispielsweise ein erster Kompressionsgrad erreichbar, wenn alle Daten gleichen Datentyps und gleichen Werts komprimiert werden. Dabei wird hier ein Datum eines solchen bestimmten Datentyps und Werts einmalig in binärer Form als Bitmuster unter einer bestimmten Adresse in dem Speicherbereich 216 abgespeichert. Sofern im Datensatz erneut Daten mit einem solchen Datentyp und einem solchen Wert vorhanden sind, so wird anstelle der tatsächlichen binären Darstellung dieser Daten, die das abgespeicherte Bitmuster hat, ein Zeiger verwendet und abgespeichert. Das Abspeichern des Zeigers erfolgt im Speicherbereich 218 des Speichers 206. Auf diese Weise wird das einmalig abgespeicherte Bitmuster für alle diejenigen Daten der Software verwendet, die diesen bestimmten Datentyp und diesen bestimmten Wert haben.

Ein zweiter Kompressionsgrad ist beispielsweise dann erreichbar, wenn auf das Kriterium des Datentyps verzichtet wird und alle diejenigen Daten, die den gleichen Wert haben, durch Zeiger ersetzt werden, die auf ein einmalig unter einer bestimmten Adresse in dem Speicherbereich 216 abgespeichertes Bitmuster zeigen. Beispielsweise ergibt eine Speicherung aller Zahlen in 16-Bit Darstellung von 0 bis 2¹⁶-1 einen maximalen Speicherbedarf von 128 kbyte. Dieser maximale Speicherbedarf für den zweiten Kompressionsgrad liegt unter demjenigen für den ersten Kompressionsgrad.

Ein dritter Kompressionsgrad ist beispielsweise dann erreichbar, wenn Daten in ihrer binären Form in Bytes aufgeteilt sind, die wiederum einzeln adressierbar sind. Dabei kann ein solches Byte oder ein Vielfaches eines solchen Bytes als Bitmuster zum komprimierten Abspeichern von Daten in binärer Form verwendet werden. In dem Speicherbereich 216 abgespeicherte Bitmuster, die byteweise adressierbar sind, werden insofern mittels einer Adressierung auf Basis eines Vielfachen eines Bytes zum komprimierten Abspeichern von Daten wiederverwendet. Diese Art des Komprimierens wird an dem nachfolgend geschilderten Beispiel deutlich.

Eine erste Zahl 5000 beträgt in binärer Form in einer Darstellung als ganze Zahl ohne Angabe des Vorzeichens, d. h. in einer Uint16 (=unsigned integer 16) Darstellung: 00010011 10001000.
Eine zweite Zahl 22222 beträgt in dieser binären Form entsprechend: 01010110 11001110.
Eine dritte Zahl 34902 beträgt in dieser binären Form entsprechend: 10001000 01010110.

Die 16-Bit Wörter sind hier in jeweils zwei Bytes aufgeteilt. Wird die erste Zahl in dem Speicherbereich 216 abgelegt, so sind die ersten beiden Bytes 1 und 2 des Speicherbereichs 216 mit den 16 Bit dieser ersten Zahl befüllt. Das erste Byte 1 ist unter einer Adresse 1 und das zweite Byte 2 unter einer Adresse 2 adressierbar abgespeichert. Wird die zweite Zahl nun an dem nächsten freien Speicherplatz in dem Speicherbereich 216 abgelegt, so sind die Bytes 3 und 4 des Speicherbereichs 216 mit den 16 Bit dieser zweiten Zahl befüllt. Das dritte Byte 3 ist unter einer Adresse 3 und das vierte Byte 4 unter einer Adresse 4 adressierbar abgespeichert. Dabei ergibt sich die nachfolgend gezeigte Abspeicherreihenfolge:

| | | | | |
|---|---|---|---|---|
| Bitmuster: | 00010011 | 10001000 | 01010110 | 11001110 |
| Speicheradressen: | 1 | 2 | 3 | 4 |

Bei dieser Darstellung ergibt sich, dass die unter den Adressen 2 und 3 abgespeicherten binären Bitmuster der dritten Zahl entsprechen. Es ist daher möglich, einen Verweis, insbesondere einen Zeiger, auf die Adresse 2 zu richten. Insbesondere in Kombination mit einem geeigneten Lesebefehl, wie er beispielsweise oben in Zusammenhang mit dem Betriebssystem 156 beschrieben wurde, werden ausgehend von der durch den Zeiger angegebenen Adresse die nachfolgenden 16 Bit ausgelesen. Es ist somit vorteilhafterweise nicht erforderlich, die dritte Zahl in vollständiger binärer Form ebenfalls abzuspeichern. Im vorliegenden Beispiel wird daher eine Reduktion des Speicherbedarfs von sechs auf vier Bytes erreicht. Ein zusätzlicher Verweis, d. h. Zeiger, auf die Speicheradresse 3 ist hier nicht erforderlich, da ein 16-Bit Wort ausgelesen werden soll. Der dritte Kompressionsgrad ist gegenüber dem zweiten Kompressionsgrad weiter erhöht, da das Adressieren des Bitmusters nicht auf Zahlen mit dem gleichen Wert begrenzt ist. Vielmehr können hier Bitmuster mehrerer Zahlen verwendet werden. Im vorliegenden Beispiel sind dies das zweite Byte der ersten Zahl und das erste Byte der zweiten Zahl.

Im vorliegenden Beispiel zu dem dritten Kompressionsgrad liegt eine Aufteilung der Daten in ihren binären Formen in Bytes vor. Es ist allerdings ebenso möglich, eine Unterteilung in andere Teil-Bitmuster, d. h. in eine andere Anzahl von aufeinander folgenden Bits, vorzunehmen. Ferner ist es möglich, jedes Teil-Bitmuster unabhängig von den anderen zu adressieren, so dass verschiedene Teil-Bitmustern zum Abspeichern anderer Bestandteile der Software beliebig kombiniert werden können. Im oben beschriebenen Beispiel zu dem dritten Kompressionsgrad könnte in diesem Fall beispielsweise das Teil-Bitmuster (Byte) unter der Adresse 2 mit dem Teil-Bitmuster (Byte) unter der Adresse 4 kombiniert werden. Dies wäre beispielsweise durch eine Verwendung von zwei Zeigern durchführbar, die miteinander kombiniert werden und auf die Speicheradressen 2 und 4 zeigen. Diese Vorgehensweise gewährleistet vorteilhafterweise einen besonders hohen Kompressionsgrad. Insbesondere große Bitmuster können insofern aus mehreren Teil-Bitmustern zusammengestellt werden. Diese Vorgehensweise ist sowohl auf den Programmcode der Software als auch auf die Daten anwendbar. Eine Variable mit einem 4 Byte großen Bitmuster kann beispielsweise auf vier Zeiger reduziert werden, die jeweils auf ein 1 Byte großes Bitmuster verweisen. Zusammengesetzt ergeben diese vier Einzelbytes das gewünschte 4 Byte große Bitmuster.

Ein vierter Kompressionsgrad ist beispielsweise dann erreichbar, wenn Daten in ihrer binären Form in Bits aufgeteilt sind, die wiederum einzeln adressierbar sind. Dabei kann ein Vielfaches eines solchen Bits als Bitmuster zum komprimierten Abspeichern von Daten in binärer Form verwendet werden. In dem Speicherbereich 216 abgespeicherte Bitmuster, die bitweise adressierbar sind, werden insofern mittels einer Adressierung auf Basis eines Vielfachen eines Bits zum komprimierten Abspeichern von Daten wiederverwendet. Übertragen auf das oben geschilderte Beispiel des dritten Kompressionsgrads wäre somit jede Speicherstelle der Bitmuster adressierbar.

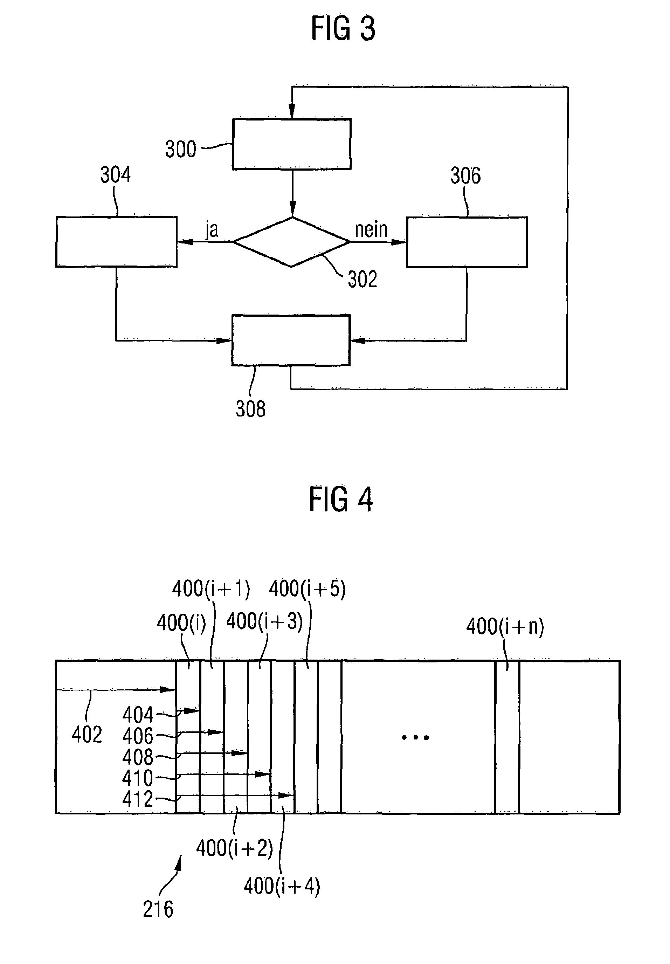

Fig. 3 zeigt ein Ausführungsbeispiel eines erfindungsgemäßen Verfahrens, mit dem ein Komprimieren mittels Wiederverwenden von abgespeicherten Bitmustern durchgeführt wird. Dargestellt ist ein Ablaufdiagramm eines Algorithmus zum Ausführen des erfindungsgemäßen Verfahrens. In einem Schritt 300 wird ein neues binäres Datum gewählt, das in dem Speicher 206 abgespeichert werden soll. In einem Schritt 302 wird überprüft, ob das binäre Datum bereits als Bitmuster in dem Speicherbereich 216 abgespeichert wurde. Ist dies der Fall, dann wird in einem Schritt 304 festgelegt, dass das bereits in dem Speicherbereich 216 abgelegte Bitmuster zum Abspeichern des neuen binären Datums verwendet wird. Zum Verweisen auf dieses Bitmuster kann ein Zeiger im Speicher 206 abgespeichert werden, der auf die Speicheradresse verweist, unter der das bereits abgespeicherte Bitmuster in dem Speicherbereich 216 abgespeichert ist. Wird im Schritt 302 festgestellt, dass das neue binäre Datum noch nicht als Bitmuster im Speicherbereich 216 abgespeichert wurde, dann wird das neue binäre Datum in einem Schritt 306 als Bitmuster anschließend an das letzte, abgespeicherte Bitmuster, d. h. am Ende eines benutzten Datenbereichs, in dem Speicherbereich 216 abgelegt. In einem Schritt 308 wird dann das Abspeichern des neuen binären Datums beendet und erneut zum Schritt 300 verzweigt, um das nächste, abzuspeichernde binäre Datum auszuwählen.

Das anhand von Fig. 3 beschriebene Verfahren zum Komprimieren kann erweitert werden, indem die Bitmuster vor ihrem Abspeichern in dem Speicherbereich 216 sortiert werden. Dabei werden Daten der Software vor ihrem Abspeichern in binärer Form daraufhin untersucht, ob sie in ihren binären Formen wenigstens ein gleiches Bitmuster aufweisen. Abhängig von einem Ergebnis des Untersuchens werden die Daten zum Abspeichern in binärer Form sortiert. Durch das Sortieren können vorteilhafterweise möglichst viele aufeinander folgende, adressierbare und wiederverwendbare Bitmuster zum Abspeichern von Bestandteilen der Software erhalten werden. Bezogen auf das oben geschilderte Beispiel des Abspeicherns von drei Zahlen gemäß dem dritten Kompressionsgrad kann durch das Sortieren beispielsweise sichergestellt werden, dass das erste Byte der zweiten Zahl unmittelbar angrenzend an das zweite Byte der ersten Zahl abgespeichert wird. Auf diese Weise kann sichergestellt werden, dass die dritte Zahl durch die bereits abgespeicherten Bitmuster dargestellt werden kann.

Fig. 4 zeigt einen Ausschnitt des Speicherbereichs 216 des Speichers 206 mit einer Vielzahl von aufeinander folgenden, adressierbaren Speicherplätzen 400(i)-400(i+n) zum Abspeichern von Bitmustern. i und n sind dabei Variablen für natürliche Zahlen. Unter jedem der adressierbaren Speicherplätze 400(i)-400(i+n) kann ein Bitmuster abgespeichert sein. Fig. 4 verdeutlicht eine besonders vorteilhafte Anwendung von Zeigern zum Adressieren der Bitmuster. Im Beispiel nach Fig. 4 ist der Speicherplatz 400(i) ein Offset-Speicherplatz, auf den ein Zeiger 402 zeigt und von dem mehrere weitere Zeiger auf weitere Speicherplätze verweisen. Ein Zeiger 404 zeigt ausgehend von dem Speicherplatz 400(i) auf den Speicherplatz 400(i+1), ein Zeiger 406 ausgehend von dem Speicherplatz 400(i) auf den Speicherplatz 400(i+2), ein Zeiger 408 ausgehend von dem Speicherplatz 400(i) auf den Speicherplatz 400(i+3), ein Zeiger 410 ausgehend von dem Speicherplatz 400(i) auf den Speicherplatz 400(i+4) und ein Zeiger 412 zeigt ausgehend von dem Speicherplatz 400(i) auf den Speicherplatz 400(i+5). Zum Adressieren von mehreren, in den Speicherplätzen 400(i+1)-400(i+5) abgespeicherten Bitmustern werden die Zeiger 404-412 verwendet. Diese Zeiger 404-412 verweisen jeweils ausgehend von dem Speicherplatz 400(i) auf die mehreren abgespeicherten Bitmuster in den Speicherplätzen 400(i+1)-400(i+5). Die Zeiger 404-412 geben insofern relative Speicheradressen an, die zusammen mit dem Zeiger 402 betrachtet werden müssen. Die Zeiger 404-412 adressieren insofern die Speicherplätze 400(i+1)-400(i+5) durch Angaben von Abweichungen von dem Offset-Speicherplatz 400(i). Auf diese Weise können beispielsweise Arrays, insbesondere mehrdimensionale Arrays, oder Elemente von Arrays, wie z. B. Matrizen, adressiert werden. Anstelle der eigentlichen Variablenwerte für die abgespeicherten Bitmuster werden somit insbesondere die Zeiger 404-412 zum Adressieren der Speicherplätze 400(i+1)-400(i+5) eingesetzt.

In den vorhergehenden Beispielen wurden im Wesentlichen Daten der Software als deren Bestandteile in komprimierter Form abgespeichert. Es ist aber ebenso möglich, den in binärer Form vorliegenden Programmcode auf die gleiche Weise zu komprimieren. Insbesondere ist es dann möglich, in dem Speicherbereich 216 abgespeicherte Bitmuster, die zum Abspeichern des Programmcodes verwendet werden, auch zum Abspeichern von Daten wiederzuverwenden.

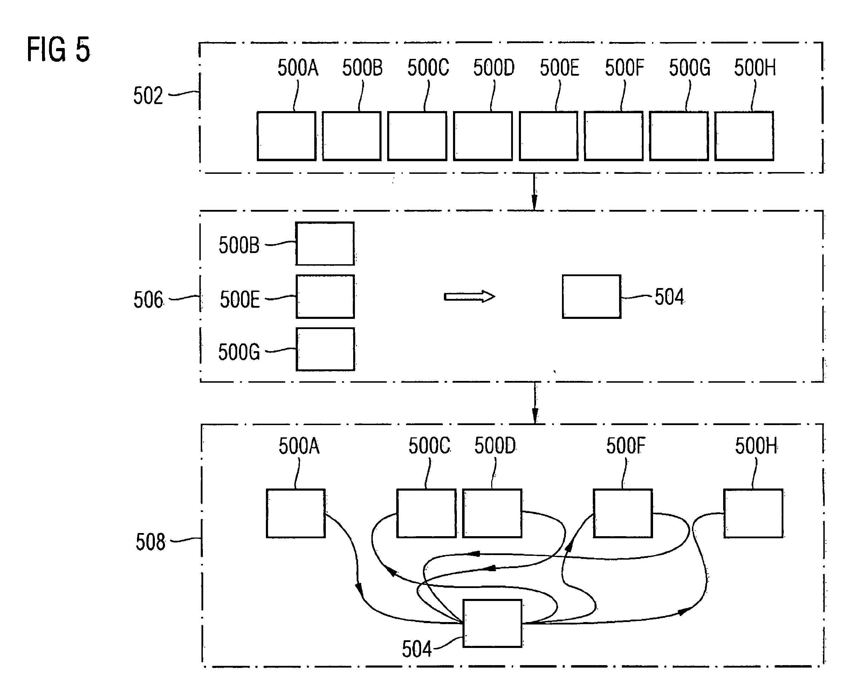

Fig. 5 zeigt ein Beispiel eines Verfahrens zum Komprimieren von Programmcode der Software. Dieser Programmcode enthält in diesem Beispiel acht Programmcodeteile 500A-500H, die bestimmte Funktionalitäten mit bestimmten Kombinationen von Rechenoperationen aufweisen. In einem Verfahrensschritt 502 werden nun die Programmcodeteile 500A-500H strukturell analysiert, um Konstrukte mit gleichen oder zumindest ähnlichen Funktionalitäten festzustellen. Diese Analyse ergibt hier, dass dies für die Programmcodeteile 500B, 500E und 500G erfüllt ist. Die Programmcodeteile 500B, 500E, 500G können daher durch einen zentralen Programmteil 504 ersetzt werden. In einem Verfahrensschritt 506 wird dieser zentrale Programmteil 504 erzeugt. Dies erfolgt so, dass er in der Lage ist, die Funktionalitäten der Programmcodeteile 500B, 500E, 500G zu erfüllen. In einem nachfolgenden Verfahrensschritt 508 wird dann der Programmcode verändert. Bei dieser Veränderung wird der Programmcode so umorganisiert, dass der im Schritt 506 erzeugte zentrale Programmteil 504 anstelle der Programmcodeteile 500B, 500E, 500G in den Programmablauf eingebunden ist. Dies bedeutet, dass beim Ausführen des Programmcodes das Programm nach dem Ausführen des Programmcodeteils 500A zu dem zentralen Programmteil 504 verzweigt und dieses Programmteil 504 ausgeführt wird. Nach dem Ausführen des Programmteils 504 wird zum Programmcodeteil 500C verzweigt. Nach dem Ausführen des Programmcodeteils 500D wird dann erneut der zentrale Programmteil 504 ausgeführt. Ist dies abgeschlossen, dann erfolgt das Ausführen des Programmcodeteils 500F. Danach wird wieder zum zentralen Programmteil 504 verzweigt, um nach dessen erneutem Ausführen weiter zum Programmcodeteil 500H zu gelangen, der abschließend ausgeführt wird. Anstelle der Programmcodeteile 500B, 500E, 500G wird somit der zentrale Programmteil 504 dreimal ausgeführt. Unter der Annahme, dass die Programmcodeteile 500B, 500E, 500G einen gleichen Speicherplatzbedarf haben, ergibt sich hier, dass der benötigte Speicherplatzbedarf durch die Verwendung des zentralen Programmteils 504 gedrittelt werden kann. Unter der weiteren Annahme, dass alle acht Programmcodeteile 500A-500H identische Größe haben, bedeutet dies folglich, dass sich die Größe des gesamten Programmcodes nach dem Komprimieren auf 75% reduziert hat.

Im Beispiel der Motorsteuerung 100 nach Fig. 1 ist der RAM-Speicher 152 vorgesehen. Dieser kann hier insbesondere ein zum Kalibrieren von Daten eingesetzter Kalibrierungs-RAM sein. Der Kalibrierungs-RAM 152 dient zum Abspeichern von für ein Ausführen von bestimmten Funktionen exakt kalibrierten Daten. Diese Daten werden in dem RAM 152 komprimiert abgespeichert. Dazu werden in dem RAM 152 möglichst ausschließlich Zeiger abgespeichert. Diese Zeiger verweisen auf die kalibrierten Daten, die in binärer Form in einem anderen Speicher abgespeichert sind. Dieser andere Speicher kann beispielsweise der Speicher 116 sein. Die Zeiger benötigen besonders wenig Speicherplatz, so dass der RAM-Speicher 152 nur eine relativ geringe Speicherkapazität benötigt und kostengünstig ausgeführt werden kann.

Im vorliegenden Beispiel werden nach dem Kalibrieren, und damit dem Verändern der Daten, in dem Kalibrierungs-RAM 152 abgespeicherte Zeiger geändert, so dass sie auf solche, in dem anderen Speicher 116 abgespeicherte Daten verweisen, die den kalibrierten Daten in binärer Form entsprechen. Dazu kann vorteilhafterweise ein geeignetes Kalibrierungssystem und ein Softwarebeschreibungsformat als Basis für das Kalibrierungssystem vorhanden sein. Zum Umsetzen kann beispielsweise ein zur Softwarebeschreibung gehörendes Wörterbuch benutzt werden. Dieses übersetzt die vom Anwender beim Kalibrieren bestimmten physikalischen Werte nicht nur in binäre Werte, sondern in einen Zeiger auf einen entsprechenden Wert in der Motorsteuerung 100, insbesondere im Speicher 116. Dieser Zeiger wird an eine definierte Stelle in dem Kalibrierungs-RAM 152 geschrieben.

## Patentansprüche

1. Verfahren zum Komprimieren einer Software für eine Steuereinrichtung (100), insbesondere eine Motorsteuereinrichtung, bei dem ein binäres Bitmuster für einen ersten Bestandteil der Software in einem Speicherbereich (216) abgespeichert und das abgespeicherte Bitmuster für einen zweiten Bestandteil der Software wiederverwendet wird.

2. Verfahren nach Anspruch 1,
**dadurch gekennzeichnet,**
**dass** der erste Bestandteil und der zweite Bestandteil Daten eines Datensatzes der Software sind, die gleiche Werte aufweisen.

3. Verfahren nach Anspruch 2,
**dadurch gekennzeichnet,**
**dass** die Daten zusätzlich Daten eines gleichen Datentyps sind.

4. Verfahren nach einem der vorhergehenden Ansprüche,
**dadurch gekennzeichnet,**
**dass** der erste Bestandteil und der zweite Bestandteil der Software Daten sind und der erste Bestandteil in binärer Form in Bytes aufgeteilt ist, die einzeln adressierbar sind, wobei ein oder ein Vielfaches eines solchen Bytes als Bitmuster für den zweiten Bestandteil verwendet wird.

5. Verfahren nach einem der vorhergehenden Ansprüche,
**dadurch gekennzeichnet,**
**dass** der erste Bestandteil und der zweite Bestandteil der Software Daten sind und der erste Bestandteil in binärer Form bitweise adressierbar ist, wobei ein Vielfaches eines solchen Bits als Bitmuster für den zweiten Bestandteil verwendet wird.

6. Verfahren nach einem der vorhergehenden Ansprüche,
**dadurch gekennzeichnet,**
**dass** überprüft wird, ob der zweite Bestandteil in binärer Form ein solches Bitmuster aufweist, das bereits zuvor für den ersten Bestandteil abgespeichert wurde, und, falls dies der Fall ist, dieses bereits abgespeicherte Bitmuster für den zweiten Bestandteil wiederverwendet wird, sowie, falls dies nicht der Fall ist, das noch nicht abgespeicherte Bitmuster des zweiten Bestandteils anschließend an ein letztes, in dem Speicherbereich (216) abgespeichertes Bitmuster neu abgespeichert wird.

7. Verfahren nach einem der vorhergehenden Ansprüche,
**dadurch gekennzeichnet,**
**dass** Bestandteile der Software, die Daten sind, daraufhin untersucht werden, ob sie in ihren binären Formen wenigstens ein gleiches Bitmuster aufweisen, und die Daten, abhängig von einem Ergebnis dieses Untersuchens, sortiert werden.

8. Verfahren nach einem der vorhergehenden Ansprüche,
**dadurch gekennzeichnet,**
**dass** zum Adressieren von mehreren abgespeicherten Bitmustern Zeiger verwendet werden, die ausgehend von einer Speicheradresse des Speicherbereichs (216) auf Speicheradressen der mehreren abgespeicherten Bitmuster verweisen.

9. Verfahren nach einem der vorhergehenden Ansprüche,
**dadurch gekennzeichnet,**
**dass** der erste Bestandteil der Software Teil eines Programmcodes der Software und der zweite Bestandteil der Software Teil eines Datensatzes der Software ist.

10. Verfahren nach einem der vorhergehenden Ansprüche,
**dadurch gekennzeichnet,**
**dass** ein Programmcode der Software zum Ermitteln von Teilen des Programmcodes analysiert wird, die gleiche oder ähnliche Funktionalitäten haben, ein zentraler Programmteil für den Programmcode erzeugt wird, der in der Lage ist, die Funktionalitäten der ermittelten Teile des Programmcodes zu erfüllen, und der Programmcode so verändert wird, dass der erzeugte zentrale Programmteil für den Ablauf des Programmcodes anstelle der ermittelten Teile des Programmcodes verwendet wird.

11. Verfahren nach Anspruch 7, 9 und 10,
**dadurch gekennzeichnet,**
**dass** zum Komprimieren des Programmcodes der Software zunächst das Verfahren nach Anspruch 10, dann zum Reduzieren einer Menge von Daten des Datensatzes der Software das Verfahren nach Anspruch 9 und anschließend zum Komprimieren der reduzierten Menge von Daten das Verfahren nach Anspruch 7 ausgeführt wird.

12. Verfahren nach einem der vorhergehenden Ansprüche,
**dadurch gekennzeichnet,**
**dass** in einem sogenannten Random Access Memory, RAM, (152), insbesondere einem zum Kalibrieren von Daten eingesetzten Kalibrierungs-RAM, Zeiger abgespeichert werden, die auf Daten verweisen, die in binärer Form in einem anderen Speicher (116) abgespeichert sind.

13. Verfahren nach Anspruch 12,
**dadurch gekennzeichnet,**
**dass** nach dem Kalibrieren, und damit einem Verändern von Daten, in dem Kalibrierungs-RAM (152) abgespeicherte Zeiger geändert werden, so dass sie auf solche in dem anderen Speicher (116) in binärer Form abgespeicherte Daten verweisen, die die kalibrierten Daten in binärer Form wiedergeben.

14. Verfahren nach einem der vorhergehenden Ansprüche,
**dadurch gekennzeichnet,**
**dass** wenigstens ein Bestandteil der Software in seiner binären Form aus mehreren Bitmustern zusammengesetzt ist, die in dem Speicherbereich (216) abgespeichert sind und einzeln, insbesondere mittels Zeigern, adressiert werden.

15. Verfahren zum Ausführen einer Software, insbesondere in einer Motorsteuereinrichtung, wobei ein Betriebssystem (156) eingesetzt wird, dessen Befehlssatz Befehle aufweist, mit denen eine Adressierung von Daten auf Basis eines Vielfachen eines Bits durchgeführt wird.

16. Verfahren zum Ausführen einer Software, insbesondere in einer Motorsteuereinrichtung, wobei eine Recheneinheit (114), insbesondere ein Prozessor, eingesetzt wird, mit dem eine Adressierung von Daten auf Basis eines Vielfachen eines Bits durchgeführt wird.

17. Verfahren nach Anspruch 15 oder 16,
**dadurch gekennzeichnet,**
**dass** die Software eine komprimierte Software ist, die nach einem Verfahren nach einem der Ansprüche 1-14 komprimiert wurde.

18. Vorrichtung (200) zum Komprimieren einer Software für eine Steuereinrichtung (100), insbesondere eine Motorsteuereinrichtung, wobei die Vorrichtung (200) einen Speicher (206) und eine Steuereinheit (202) aufweist, die mit dem Speicher (206) verbunden, und die Vorrichtung (200) so ausgestaltet ist, dass sie ein binäres Bitmuster für einen ersten Bestandteil der Software in einem Speicherbereich (216) des Speichers (206) abspeichert und das abgespeicherte Bitmuster für einen zweiten Bestandteil der Software wiederverwendet.

19. Betriebssystem (156), insbesondere für eine Motorsteuereinrichtung, das einen Befehlssatz mit Befehlen enthält, mit denen eine Adressierung von Daten auf Basis eines Vielfachen eines Bits durchführbar ist.

20. Recheneinheit (114), insbesondere Prozessor, insbesondere für eine Motorsteuereinrichtung, wobei die Recheneinheit (114) so ausgestaltet ist, dass eine Adressierung von Daten auf Basis eines Vielfachen eines Bits durchführbar ist.
